# EUROPÄISCHE PATENTANMELDUNG

(11) **EP 4 664 084 A1**
(43) Veröffentlichungstag der Anmeldung: **17.12.2025**
(21) Anmeldenummer: 25181916.5
(22) Anmeldetag: 10.06.2025
(51) Int. Cl.: G01L 1/18, G01L 1/20

(54) **FOLIENSENSOR ZUR KRAFTDETEKTION MIT DIREKTKRAFTAUFNEHMER**

(30) Priorität: 11.06.2024 DE 102024116212; 04.12.2024 DE 102024135994
(71) Anmelder: addSensors GmbH, 32339 Espelkamp (DE)
(72) Erfinder: KOTTKAMP, Eike Wilhelm, 32312 Lübbecke (DE)
(74) Vertreter: Aulich, Martin

(57) **Zusammenfassung**

Die vorliegende Erfindung betrifft einen Foliensensor zur Kraftdetektion mit Direktkraftaufnehmer, mit einer entsprechend elektrischen Kontaktleitung zur Erfassung von Kräften und Kraftbelastungen, wobei von dem Foliensensor zur Kraftdetektion mit Direktkraftaufnehme ein elektrisches Signal abgeleitet werden kann. Auf dem Kunststoff-Folienmaterial (11) werden mindestens zwei leitfähige Elektroden (12) aufgebracht, welche an den Zuleitungen einem Kontaktierungsbereich (13) aufweisen. Auf dieser den leitfähigen Elektroden (12) zugewandten Oberfläche des Kunststoff-Folienmaterials (11) ist ein Direktkraftaufnehmer (21) aufgebracht, welcher die mechanischen Kräfte, welche auf die Oberfläche wirken, aufnimmt und sich unter Krafteinwirkung elastisch verformt. Der Direktkraftaufnehmer (21) überdeckt dabei die leitfähigen Elektroden (12) nicht oder nur partiell, zudem überdeckt der Direktkraftaufnehmer (21) den Kontaktierungsbereich (13) nicht. Ebenfalls auf dieser den leitfähigen Elektroden (12) zugewandten Oberfläche des Kunststoff-Folienmaterials (11) ist ein Polymer-Nanoverbundwerkstoff (31) aufgesetzt, insbesondere so, dass die leitfähigen Elektroden (12) vollflächig oder überwiegend von dem Polymer-Nanoverbundwerkstoff (31) überdeckt werden. Der Polymer-Nanoverbundwerkstoff (31) berührt den Direktkraftaufnehmer (21) nicht oder nur partiell, wodurch zwischen Polymer-Nanoverbundwerkstoff (31) und dem Direktkraftaufnehmer (21) ein Freibereich (32) entsteht. Die elastische Materialkomprimierung vom Polymer-Nanoverbundwerkstoff (31) kann mittels einer Impedanz und oder elektrischen Widerstandmessung über die leitfähigen Elektroden (12), detektiert werden.

## Beschreibung

Die vorliegende Erfindung betrifft einen Foliensensor zur Kraftdetektion mit Direktkraftaufnehmer, mit einer entsprechend elektrischen Kontaktleitung zur Erfassung von Kräften und Kraftbelastungen, wobei von dem Foliensensor zur Kraftdetektion mit Direktkraftaufnehme ein elektrisches Signal abgeleitet werden kann. Die Erfindung betrifft des Weiteren eine Messeinrichtung mit einem solchen Foliensensor.

Kraftsensoren spielen eine entscheidende Rolle in einer Vielzahl von Anwendungen, die von industriellen Automatisierungen bis hin zu biomedizinischen Geräten reichen. Diese Sensoren messen Kräfte und liefern wesentliche Daten für die Steuerung, Überwachung und Analyse von Prozessen. Die technologische Entwicklung von Kraftsensoren hat in den letzten Jahrzehnten erhebliche Fortschritte gemacht, was zu erhöhter Genauigkeit, Zuverlässigkeit und Vielseitigkeit geführt hat.

Es gibt verschiedene Typen von Kraftsensoren, die jeweils auf unterschiedlichen Funktionsprinzipien basieren. DMS-basierte Sensoren (Dehnungsmessstreifen) nutzen die Veränderung des elektrischen Widerstands eines Materials, wenn es deformiert wird. Diese Sensoren sind universell einsetzbar, insbesondere in industriellen Anwendungen und im Maschinenbau. Sie zeichnen sich durch hohe Empfindlichkeit und gute Linearität aus, sind jedoch temperaturabhängig und erfordern Kalibrierung.

Piezoelektrische Sensoren, die auf Materialien basieren, die elektrische Ladung erzeugen, wenn sie mechanisch belastet werden, eignen sich besonders für dynamische Kraftmessungen und Schwingungsanalysen. Sie bieten hohe Empfindlichkeit und schnelle Reaktionszeiten, sind jedoch für statische Kraftmessungen weniger geeignet.

Kapazitive Sensoren messen die Veränderung der Kapazität zwischen zwei Elektroden bei mechanischer Belastung. Sie sind in der Druckmessung, in medizinischen Geräten und in der Robotik weit verbreitet und bieten hohe Genauigkeit sowie geringe Hysterese, reagieren jedoch empfindlich auf Umwelteinflüsse.

Induktive Sensoren erfassen die Veränderung der Induktivität einer Spule durch die Verschiebung eines ferromagnetischen Kerns und finden Anwendung in der Positionserfassung und in der Automobilindustrie. Sie sind besonders robust und zuverlässig, erfordern jedoch komplexere Elektronik und Kalibrierung.

Aktuelle Entwicklungen und Trends bei Kraftsensoren umfassen die Miniaturisierung und Integration, insbesondere durch Fortschritte in der Mikroelektronik und MEMS-Technologie (Micro-Electro-Mechanical Systems). Dies ermöglicht die Herstellung von extrem kleinen Sensoren, die in der Medizintechnik und in tragbaren Geräten eingesetzt werden. Die drahtlose Sensorik hat ebenfalls an Bedeutung gewonnen, da sie eine Echtzeit-Datenübertragung und Fernüberwachung ermöglicht, was besonders in schwer zugänglichen oder gefährlichen Umgebungen von Vorteil ist.

Neue Materialien wie Graphen und piezoresistive Polymere bieten verbesserte Empfindlichkeit und Flexibilität und werden zunehmend in flexiblen und dehnbaren Sensoren verwendet, die für die Robotik und Wearable-Technologie relevant sind. Darüber hinaus ermöglicht die Integration von künstlicher Intelligenz (KI) und fortschrittlichen Datenanalysetools eine bessere Interpretation der Sensordaten, die Vorhersage von Systemausfällen und die Optimierung von Prozessen in Echtzeit.

Trotz dieser Fortschritte gibt es weiterhin Herausforderungen, insbesondere in Bezug auf die präzise Kalibrierung und die Aufrechterhaltung der Genauigkeit über die Lebensdauer der Sensoren. Forschungen zielen darauf ab, selbstkalibrierende Systeme und adaptive Algorithmen zu entwickeln. Auch die Umweltfaktoren stellen eine Herausforderung dar, da die Leistung von Kraftsensoren durch Temperatur, Feuchtigkeit und andere Einflüsse beeinträchtigt werden kann.

Zukünftige Entwicklungen zielen darauf ab, die Widerstandsfähigkeit der Sensoren gegenüber solchen Einflüssen zu verbessern.

Zusammenfassend lässt sich sagen, dass die Technologie der Kraftsensoren erhebliche Fortschritte gemacht hat, was ihre Genauigkeit, Zuverlässigkeit und Anwendungsbreite betrifft. Die fortlaufende Forschung und Entwicklung in den Bereichen Materialien, Elektronik und Datenverarbeitung wird weiterhin neue Möglichkeiten und Verbesserungen bringen, die die Zukunft der Kraftmessung prägen werden.

Es besteht ein Bedürfnis, Kraftsensoren weiter zu miniaturisieren und flexible zu gestalten.

Ausgehend hiervon ist es Aufgabe der vorliegenden Erfindung, einen flexiblen und von der Aufbauhöhe reduzierten Kraftsensor, welcher über eine Impedanz und oder Widerstandsmessung ausgewertet wird, zu beschreiben.

Diese Aufgabe wird gelöst durch einen Foliensensor zur Kraftdetektion mit Direktkraftaufnehmer mit den Merkmalen des Anspruchs 1 bzw. der weiteren Ausführungsbeispiele eines solchen Verbundbauteils mit den Merkmalen der Ansprüche 2-9 sowie durch eine Messeinrichtung mit den Merkmalen des Anspruchs 10.

Erfindungsgemäß kann ein Foliensensor zur Kraftdetektion mit Direktkraftaufnehmer ein Verbundbauteil aufweisen bzw. als solches ausgebildet sein, wobei auf einer Polymerfolie leitfähige Elektroden-Leiterbahnen aufgebracht sein können, welche bevorzugt insbesondere mit einem Polymer-Nanoverbundwerkstoff vollflächig oder partiell überdeckt sind und insbesondere außerhalb der Polymer-Nanoverbundwerkstofffläche und außerhalb oder partiell oberhalb der leitfähigen Elektroden-Leiterbahnenfläche, wobei der Foliensensor einen Direktkraftaufnehmer aufweist, vorzugweise aus einem Polymerwerkstoff oder Metall. Auf die Elektroden-Leiterbahnfläche und/oder auf den Direktkraftaufnehmer kann Polymerfolie aufgesetzt sein, wobei die elektrische Kontaktierung auf der Polymerfolie jedoch frei zugänglich verbleibt.

Ein solches Verbundbauteil erlaubt es, höhere Kräfte zu detektieren, wobei der Direktkraftaufnehmer die direkt einwirkenden Kräfte aufnimmt und sich entsprechend seiner Materialeigenschaften elastisch verformt. Die entsprechende Einfederung der Direktkraftaufnehmers führt zu einer unmittelbaren Kraftbelastung auf den Polymer-Nanoverbundwerkstoff, welcher ebenfalls elastisch komprimiert wird. Diese Komprimierungsveränderung des Polymer-Nanoverbundwerkstoffs führt zu einer Änderung des durch die leitfähigen Elektroden-Leiterbahnen implizierten elektrischen Feldes und oder den elektrischen Widerstand, gemessen zwischen den mindestens zwei leitfähigen Elektroden-Leiterbahnen, welche vorzugsweise als Interdigital Elektrodenstruktur (IDES) ausgebildet sind.

Durch Materialänderung des Direktkraftaufnehmers kann der Kraftmessbereich eines erfindungsgemäß aufgeführten Foliensensors zur Kraftdetektion mit Direktkraftaufnehmer angepasst werden, was eine einfache Anpassung auf unterschiedliche sensorische Kraftdetektionsanwendungen ermöglicht und somit ein breiter Anwendungsbereich der Erfindung darstellt.

Auf dem Kunststoff-Folienmaterial (11) werden mindestens zwei leitfähige Elektroden (12) aufgebracht, welche an den Zuleitungen einen Kontaktierungsbereich (13) aufweisen. Auf dieser Oberfläche des Kunststoff-Folienmaterials (11) der der leitfähigen Elektroden (12) zugewandten Oberfläche ist ein Direktkraftaufnehmer (21) aufgebracht, welcher die mechanischen Kräfte, welche auf die Oberfläche wirken, aufnimmt und sich unter Krafteinwirkung elastisch verformt. Der Direktkraftaufnehmer (21) überdeckt dabei die leitfähigen Elektroden (12) nicht oder nur partiell, zudem überdeckt der Direktkraftaufnehmer (21) den Kontaktierungsbereich (13) nicht.

Ebenfalls auf dieser Oberfläche des Kunststoff-Folienmaterial (11), der der leitfähigen Elektroden (12) zugewandten Oberfläche, ist ein Polymer-Nanoverbundwerkstoff (31) aufgesetzt, insbesondere so, dass die leitfähigen Elektroden (12) vollflächig oder überwiegend von dem Polymer-Nanoverbundwerkstoff (31) überdeckt werden. Das Polymer-Nanoverbundwerkstoff (31) berührt den Direktkraftaufnehmer (21) nicht oder nur partiell, wodurch zwischen Polymer-Nanoverbundwerkstoff (31) und dem Direktkraftaufnehmer (21) ein Freibereich (32) entsteht.

Die dem Kunststoff-Folienmaterial (11) abgewandten Oberflächen vom Polymer-Nanoverbundwerkstoff (31) und dem Direktkraftaufnehmer (21) verlaufen planar auf einer Ebene. Diese Planarität von Direktkraftaufnehmer (21) und dem Polymer-Nanoverbundwerkstoff (31) kann auch mittels einem Spacer (33), welcher über dem Polymer-Nanoverbundwerkstoff (31) eingebracht wird ausgeführt werden, wobei der Spacer (33) aus einem härteren Material und somit weniger elastischem Material ausgeführt wird als wie das Polymer-Nanoverbundwerkstoff (31)
Erfindungsgemäß wird bei einer flächigen Krafteinwirkung, welche auf die dem Kunststoff-Folienmaterial (11) abgewandten Oberflächen vom Polymer-Nanoverbundwerkstoff (31) und dem Direktkraftaufnehmer (21) wirkt, eine elastisches Materialkomprimierung vom Polymer-Nanoverbundwerkstoff (31) und dem Direktkraftaufnehmer (21) erzeugt. Diese elastisches Materialkomprimierung vom Polymer-Nanoverbundwerkstoff (31), kann mittels einer Impedanz und oder elektrischen Widerstandmessung über die leitfähigen Elektroden (12), wobei die entsprechende Auswerte- und Messelektronik an den Kontaktierungsbereich (13) angeschlossen wird, detektiert werden. Durch die elastische Materialkomprimierung vom Polymer-Nanoverbundwerkstoff (31) und dem Direktkraftaufnehmer (21) werden beide Elemente des Verbundbauteil verformt, insbesondere verformen sich Polymer-Nanoverbundwerkstoff (31) und Direktkraftaufnehmer (21) in den Freibereich (32).

Was die Abmessungen vom Polymer-Nanoverbundwerkstoff (31) und dem Direktkraftaufnehmer (21) betrifft, so sind hier Materialdicken von 50µm bis 1.000µm denkbar, besonders bevorzugt jedoch 100µm bis 400µm.

Was die Abmessungen der leitfähigen Elektroden (12), welche auf dem Kunststoff-Folienmaterial (11) aufgebracht sind betrifft, so sind hier eine Leiterbahnbreiten und ein Leiterbahnabstand, der vorzugsweise als Interdigital Elektrodenstruktur (IDES) ausgeprägten aktiven Elektrodenfläche, von 25µm bis 1.000µm denkbar, besonders bevorzugt jedoch 50µm bis 400µm.

Eine weitere erfindungsmäßige Variante ist, dass auf der planaren Oberfläche von Polymer-Nanoverbundwerkstoff (31) und Direktkraftaufnehmer (21) eine Kraftverteilungsplatte (41) aufgesetzt wird, welche eine punktuelle oder partielle Krafteinwirkung auf die gesamte planare Oberfläche von Polymer-Nanoverbundwerkstoff (31) und Direktkraftaufnehmer (21) verteilt.

Eine weitere erfindungsmäßige Variante ist, dass die Oberfläche des Verbundbauteils mit einer Schutzfolie (51) überdeckt ist, insbesondere so, dass die Schutzfolie (51) mit der Oberfläche der Kunststoff-Folienmaterial (11) verbunden wird und die Schutzfolie (51) den Polymer-Nanoverbundwerkstoff (31) und den Direktkraftaufnehmer (21) vollflächig überdeckt und einhaust.

Eine weitere erfindungsmäßige Variante ist, dass der Direktkraftaufnehmer (21) nicht nur im äußeren Bereich des Kunststoff-Folienmaterials (11) und des Polymer-Nanoverbundwerkstoffs (31) angeordnet wird, sondern auch in die Fläche des Kunststoff-Folienmaterial (11) wo die leitfähigen Elektroden (12) angeordnet sind verläuft und aufgebracht wird, wobei das Polymer-Nanoverbundwerkstoff (31) in diesem über die Fläche des Kunststoff-Folienmaterial (11) wo die leitfähigen Elektroden (12) angeordnet sind und der Direktkraftaufnehmer (21) aufgebracht wird, freigestellt ist.

Weitere Merkmale der vorliegenden Erfindung ergeben sich aus den beigefügten Patentansprüchen, der nachfolgenden Beschreibung bevorzugter Ausführungsbeispiele sowie aus den beigefügten Zeichnungen. Darin zeigt:

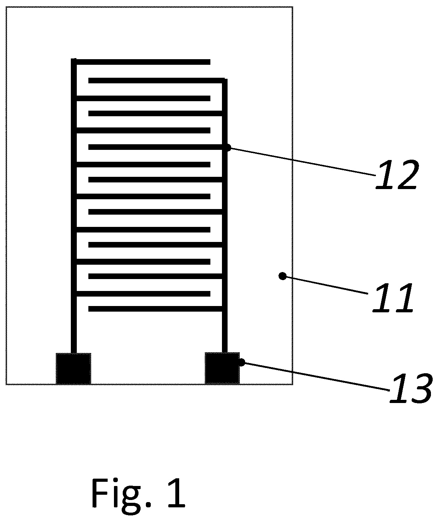

Fig. 1 zeigt einen schematischen Aufbau von Kunststoff-Folienmaterial (11) mit aufgebrachten leitfähigen Elektroden (12) und Kontaktierungsbereich (13).

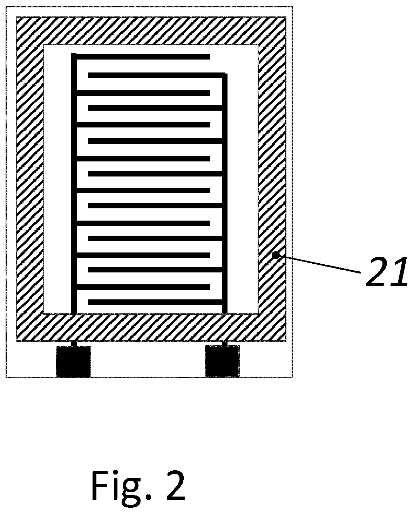

Fig. 2 zeigt einen schematischen Aufbau von Kunststoff-Folienmaterial (11) mit aufgebrachten leitfähigen Elektroden (12) und Kontaktierungsbereich (13), sowie aufgesetztem Direktkraftaufnehmer (21).

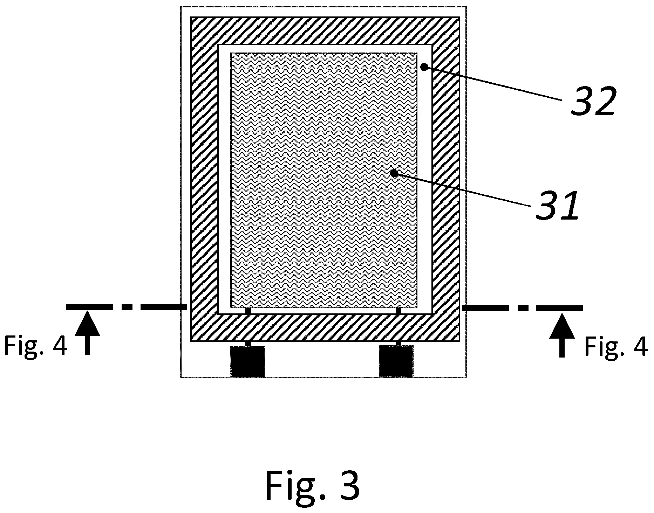

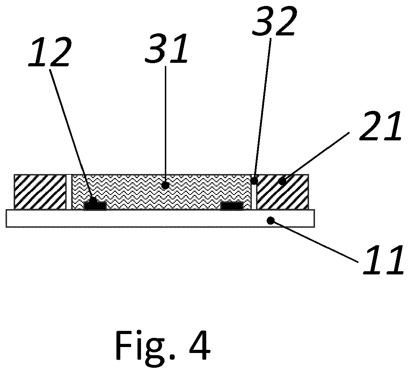

Fig. 3 zeigt einen schematischen Aufbau von Kunststoff-Folienmaterial (11) mit aufgebrachten leitfähigen Elektroden (12) und Kontaktierungsbereich (13), sowie aufgesetztem Direktkraftaufnehmer (21), sowie aufgesetztem Polymer-Nanoverbundwerkstoff (31). Zudem enthält die Fig. 3 Schnittlinien welche auf die Schnittdarstellung in Fig. 4 verweisen.
Fig. 4 zeigt eine Schnittdarstellung der erfindungsgemäßen Ausprägung der Idee nach Anspruch 1.

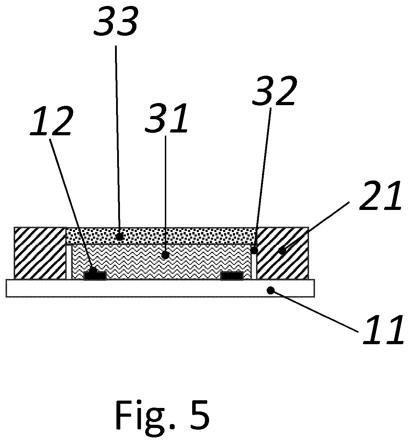

Fig. 5 zeigt eine Schnittdarstellung der erfindungsgemäßen Ausprägung der Idee nach Anspruch 2, wobei über dem Polymer-Nanoverbundwerkstoff (31) ein Spacer (33) eingebracht wird, welcher eine planare Oberfläche zum Direktkraftaufnehmer (21) ausbildet.

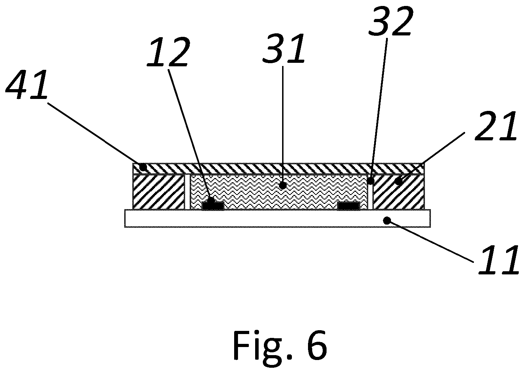

Fig. 6 zeigt eine Schnittdarstellung der erfindungsgemäßen Ausprägung der Idee, wobei über dem Polymer-Nanoverbundwerkstoff (31) und dem Direktkraftaufnehmer (21) eine Kraftverteilungsplatte (41) eingebracht ist, welche eine flächige Krafteinwirkung auf den Polymer-Nanoverbundwerkstoff (31) und dem Direktkraftaufnehmer (21) erzeugt.

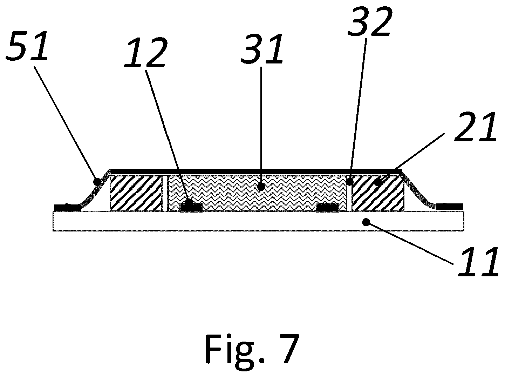

Fig. 7 zeigt eine Schnittdarstellung der erfindungsgemäßen Ausprägung der Idee, wobei eine Schutzfolie (51) den Polymer-Nanoverbundwerkstoff (31) und den Direktkraftaufnehmer (21) vollflächig überdeckt und einhaust.

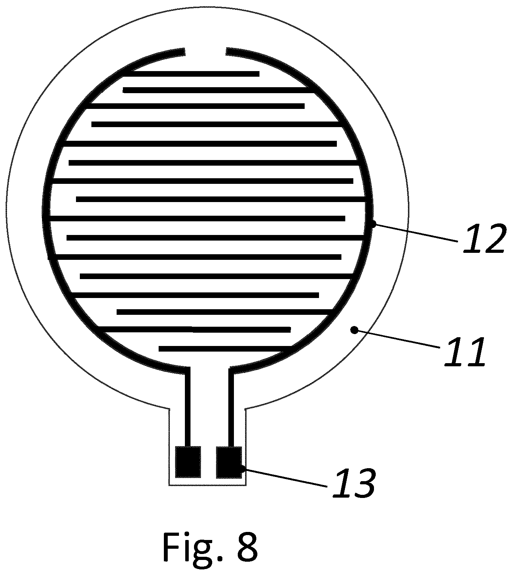

Fig. 8 zeigt einen weiteren schematischen Aufbau und mögliche geometrische Ausprägung von Kunststoff-Folienmaterial (11) mit aufgebrachten leitfähigen Elektroden (12) und Kontaktierungsbereich (13).

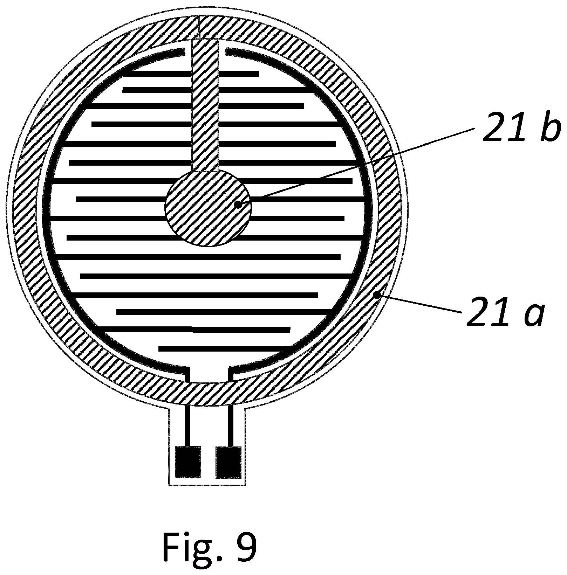

Fig. 9 zeigt einen weiteren schematischen Aufbau und mögliche geometrische Ausprägung von Kunststoff-Folienmaterial (11) mit aufgebrachten leitfähigen Elektroden (12) und Kontaktierungsbereich (13), sowie aufgesetzten Direktkraftaufnehmer (21), wobei der Direktkraftaufnehmer (21) insbesondere auf der Fläche des Kunststoff-Folienmaterial (11) wo die leitfähigen Elektroden (12) angeordnet, verläuft.

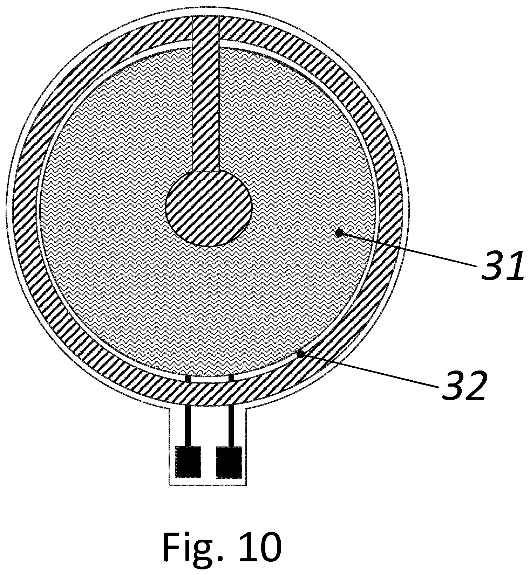

Fig. 10 zeigt einen weiteren schematischen Aufbau und mögliche geometrische Ausprägung von Kunststoff-Folienmaterial (11) mit aufgebrachten leitfähigen Elektroden (12) und Kontaktierungsbereich (13), sowie aufgesetzten Direktkraftaufnehmer (21), wobei der Direktkraftaufnehmer (21) insbesondere auf der Fläche des Kunststoff-Folienmaterials (11) wo die leitfähigen Elektroden (12) angeordnet sind, verläuft, wobei der Polymer-Nanoverbundwerkstoff (31) in diesem über der Fläche des Kunststoff-Folienmaterials (11) wo die leitfähigen Elektroden (12) angeordnet sind und der Direktkraftaufnehmer (21) aufgebracht wird, freigestellt ist.

Bevorzugte Ausführungsbeispiele:
1. Foliensensor mit mindestens einem neben und oder über den leitfähigen Elektroden (12), welche auf einem Kunststoff-Folienmaterial (11) aufgebracht sind, angeordneten Direktkraftaufnehmer (21), wobei in einem, dem oder jedem Raum zwischen leitfähigen Elektroden (12), welche auf dem Kunststoff-Folienmaterial (11) aufgebracht sind und dem Direktkraftaufnehmer (21) mindestens ein Polymer-Nanoverbundwerkstoff (31) eingebracht ist.
2. Foliensensor gemäß Anspruch 1, **dadurch gekennzeichnet,** dass oberhalb des Polymer-Nanoverbundwerkstoff (31) ein Spacer (33) eingebracht wird, welcher eine planare Oberfläche zum Direktkraftaufnehmer (21) ausbildet.
3. Foliensensor gemäß einem oder mehreren der vorhergehenden Ansprüche, **dadurch gekennzeichnet,** dass der Direktkraftaufnehmer (21) mit dem Kunststoff-Folienmaterial (11) verbunden wird, vorzugsweise mittels einer Klebe- oder Schweißverbindung
4. Foliensensor gemäß einem oder mehreren der vorhergehenden Ansprüche, **dadurch gekennzeichnet,** dass über dem Polymer-Nanoverbundwerkstoff (31) und dem Direktkraftaufnehmer (21) eine Kraftverteilungsplatte (41) eingebracht wird, welche eine flächige Krafteinwirkung auf den Polymer-Nanoverbundwerkstoff (31) und dem Direktkraftaufnehmer (21) erzeugt.
5. Foliensensor gemäß einem oder mehreren der vorhergehenden Ansprüche, **dadurch gekennzeichnet,** dass eine Schutzfolie (51) den Polymer-Nanoverbundwerkstoff (31) und den Direktkraftaufnehmer (21) vollflächig überdeckt und einhaust.
6. Foliensensor gemäß einem oder mehreren der vorhergehenden Ansprüche, **dadurch gekennzeichnet,** dass die leitfähigen Elektroden (12) eine Interdigital Elektrodenstruktur (IDES) aus einem elektrisch leitfähigen Material aufweisen, insbesondere aus einem Kupfer, Silber, Carbon oder Metalllegierungsmaterial, sowie das Kunststoff-Folienmaterial (11) eine flexible Polymerfolie ist, insbesondere ein PC, PA, PE, PEEK, PEI, PES, PP, PMMA, PS, PVC, PSU, PET, PEN, PI, FEP oder TPU - Kunststoffmaterial ist.
7. Foliensensor gemäß einem oder mehreren der vorhergehenden Ansprüche, **dadurch gekennzeichnet,** dass die leitfähigen Elektroden (12) eine Interdigital Elektrodenstruktur (IDES) aus einem elektrisch leitfähigen Material aufweisen, wobei insbesondere eine Leiterbahnbreite von 25µm bis 1.000µm, vorzugsweise zwischen 50µm und 400µm aufweist, wobei das Verhältnis von Leiterbahn und Leiterbahnabstand gleich ist.
8. Foliensensor gemäß einem oder mehreren der vorhergehenden Ansprüche, **dadurch gekennzeichnet,** dass der Polymer-Nanoverbundwerkstoff (31) eine Materialdicke von 50µm bis 1.000µm, vorzugsweise 100µm bis 400µm aufweist.
9. Foliensensor gemäß einem oder mehreren der vorhergehenden Ansprüche, **dadurch gekennzeichnet,** dass der Direktkraftaufnehmer (21) aus einem Metall, Keramischen oder Polymeren Material besteht, jedoch immer ein höheres Elastizitätsmodul aufweist als der Polymer-Nanoverbundwerkstoff (31).
10. Messeinrichtung, zur Detektion von Kraftbelastungen durch eine Impedanz- und oder elektrische Widerstandsmessung, mittels einem nach einem der Ansprüche 1 bis 9 ausgeführten Foliensensor.

### Bezugszeichenliste:

- 11: Kunststoff-Folienmaterial
- 12: leitfähige Elektroden
- 13: Kontaktierungsbereich
- 21: Direktkraftaufnehmer
- 21 a: Direktkraftaufnehmer außerhalb
- 21 b: Direktkraftaufnehmer innerhalb
- 31: Polymer-Nanoverbundwerkstoff
- 32: Freibereich
- 33: Spacer
- 41: Kraftverteilungsplatte
- 51: Schutzfolie

## Patentansprüche

1. Foliensensor mit mindestens einem neben und oder über leitfähigen Elektroden (12), welche auf einem Kunststoff-Folienmaterial (11) aufgebracht sind, angeordneten Direktkraftaufnehmer (21), wobei in einem, dem oder jedem Raum zwischen den leitfähigen Elektroden (12), welche auf dem Kunststoff-Folienmaterial (11) aufgebracht sind, und dem Direktkraftaufnehmer (21) mindestens ein Polymer-Nanoverbundwerkstoff (31) eingebracht ist.

2. Foliensensor gemäß Anspruch 1, **dadurch gekennzeichnet, dass** oberhalb des Polymer-Nanoverbundwerkstoffs (31) ein Spacer (33) eingebracht ist, welcher eine planare Oberfläche zum Direktkraftaufnehmer (21) ausbildet.

3. Foliensensor gemäß einem oder mehreren der vorhergehenden Ansprüche, **dadurch gekennzeichnet, dass** der Direktkraftaufnehmer (21) mit dem Kunststoff-Folienmaterial (11) verbunden ist, vorzugsweise mittels einer Klebe- oder Schweißverbindung.

4. Foliensensor gemäß einem oder mehreren der vorhergehenden Ansprüche, **dadurch gekennzeichnet, dass** über dem Polymer-Nanoverbundwerkstoff (31) und dem Direktkraftaufnehmer (21) eine Kraftverteilungsplatte (41) eingebracht ist, welche eine flächige Krafteinwirkung auf den Polymer-Nanoverbundwerkstoff (31) und den Direktkraftaufnehmer (21) erzeugt.

5. Foliensensor gemäß einem oder mehreren der vorhergehenden Ansprüche, **dadurch gekennzeichnet, dass** eine Schutzfolie (51) den Polymer-Nanoverbundwerkstoff (31) und den Direktkraftaufnehmer (21) vollflächig überdeckt und einhaust.

6. Foliensensor gemäß einem oder mehreren der vorhergehenden Ansprüche, **dadurch gekennzeichnet, dass** die leitfähigen Elektroden (12) eine Interdigital Elektrodenstruktur (IDES) aus einem elektrisch leitfähigen Material aufweisen, insbesondere aus einem Kupfer, Silber, Carbon oder Metalllegierungsmaterial, und dass das Kunststoff-Folienmaterial (11) eine flexible Polymerfolie ist, insbesondere ein PC, PA, PE, PEEK, PEI, PES, PP, PMMA, PS, PVC, PSU, PET, PEN, PI, FEP oder TPU - Kunststoffmaterial.

7. Foliensensor gemäß einem oder mehreren der vorhergehenden Ansprüche, **dadurch gekennzeichnet, dass** die leitfähigen Elektroden (12) eine Interdigital Elektrodenstruktur (IDES) aus einem elektrisch leitfähigen Material aufweisen, insbesondere mit einer Leiterbahnbreite von 25µm bis 1.000µm, vorzugsweise zwischen 50µm und 400µm, wobei bevorzugt das Verhältnis von Leiterbahn und Leiterbahnabstand gleich ist.

8. Foliensensor gemäß einem oder mehreren der vorhergehenden Ansprüche, **dadurch gekennzeichnet, dass** der Polymer-Nanoverbundwerkstoff (31) eine Materialdicke von 50µm bis 1.000µm, vorzugsweise 100µm bis 400µm aufweist.

9. Foliensensor gemäß einem oder mehreren der vorhergehenden Ansprüche, **dadurch gekennzeichnet, dass** der Direktkraftaufnehmer (21) aus einem Metall, keramischen oder polymeren Material besteht, jedoch immer ein höheres Elastizitätsmodul aufweist als der Polymer-Nanoverbundwerkstoff (31).

10. Messeinrichtung, zur Detektion von Kraftbelastungen durch eine Impedanz- und oder elektrische Widerstandsmessung, mittels einem nach einem der Ansprüche 1 bis 9 ausgeführten Foliensensor.
